# EUROPEAN PATENT SPECIFICATION

(11) **EP 4 459 293 B1**
(45) Date of publication and mention of the grant of the patent: **20.08.2025**
(21) Application number: 23171954.3
(22) Date of filing: 05.05.2023
(51) Int. Cl.: G01R 15/20

(54) **CURRENT TRANSDUCER MODULE**
STROMWANDLERMODUL
MODULE DE TRANSDUCTEUR DE COURANT

(43) Date of publication of application: 06.11.2024
(73) Proprietor: LEM International SA, 1217 Meyrin (CH)
(72) Inventor: CERUTTI, Dylan, 74160 Saint-Julien-en-Genevois (FR); COUTELLIER, Damien, 01700 MIRIBEL (FR); LABBE, Arnaud, 73410 ST. GIROD (FR); SERBOUH, Sofiane, 81829 Munich (DE)
(74) Representative: reuteler & cie SA

(56) References cited:
- EP-A1- 3 306 325
- WO-A1-2012/137389
- KR-A- 20210 085 664
- US-A1- 2022 229 093

## Description

The present invention relates to an open loop current transducer module for mounting on a primary conductor unit.

Many conventional open loop current transducers comprise a magnetic core with an air gap in which a magnetic field detector is positioned for measuring a magnetic field induced by a primary conductor carrying a current to be measured by the magnetic core. Such open loop type of current transducers are widely used in current sensing applications in view of their durability, large current measuring range and low cost, in particular including the low cost of the electronics required to drive the current transducer circuit.

In many conventional open loop transducers for a large operating range, it is typical to provide a single magnetic core surrounding a central passage through which a primary conductor bar extends, the magnetic core comprising an airgap in which a magnetic field detector, typically a Hall effect detector, is mounted. In many high current applications, the primary conductor bar forms part of the transducer and has connection ends configured to be connected to a conductor carrying the current to be measured. The integration of the primary conductor in the transducer facilitates installation and connection of the transducer to the system in which it is implemented to measure a primary current. Integration of the primary conductor bar in the current transducer also avoids a more complex current transducer arrangement requiring a split magnetic core, for instance mounted in a two-part hinge coupled housing that can be assembled around a primary conductor bar. It however has drawbacks in that it increases the overall size of the arrangement current transducer and external system to which the current transducer is coupled. The additional interconnections between the primary conductor bar section and the external circuit are also sources of potential problems especially in harsh environments with vibration, and mechanical and thermally caused stresses.

In particular, in power inverter applications which form components that require further integration in the external systems such as motor drives, the available space for integrating components such as current transducers may be rather limited while the requirement for low cost, durable, accurate and easy to install current transducer subsists.

Various current measuring devices for mounting against a primary conductor bar for measuring a current flowing in the primary conductor bar are disclosed in EP3306325, KR20210085664, US2022229093, WO2012137389.

In view of the foregoing, it is an object of this invention to provide a compact, yet robust, durable and reliable open-loop current transducer that is also economical to produce and install.

It is advantageous to provide an open loop current transducer that has a large operating range and that is for use in harsh operating environments in particular subject to mechanical vibrations, shock and large thermal variations such as in automotive or other mobile applications.

A specific object of the invention is to provide a compact yet robust, durable and reliable open loop current transducer for measuring currents in a power inverter, in particular for electric motor drives, for instance electrical motors for automotive applications, that is economical to produce and install.

In certain applications in particular power inverters for electrical motor drives, the current transducer should be able to operate in a current measurement range of up to 1000 A.

Objects of the invention have been achieved by providing a current transducer module according to claim 1.

Dependent claims set out various advantageous features of embodiments of the invention.

Disclosed herein is a current transducer module comprising
- a housing having a base wall and side walls forming an internal cavity,
- a magnetic core part,
- magnetic field detectors, and
- a circuit board,

the magnetic core part, magnetic field detectors, and the circuit board mounted within the internal cavity of the housing,
the magnetic core part extending from a first core end to a second core end, the magnetic field detectors comprising a first magnetic field detector positioned opposite the first core end and a second magnetic detector positioned opposite the second core end, the magnetic field detectors connected to the circuit board and arranged substantially co-planar with respect to each other. The magnetic field detectors are mounted against the base wall of the housing and the magnetic core part is mounted above the magnetic field detectors such that the magnetic field detectors are positioned in a gap between the housing base wall and the magnetic core part.

In an advantageous embodiment, the magnetic field detectors are mounted on a first primary conductor facing side of the circuit board and the magnetic core part is mounted on a second side of the circuit board, opposite the first primary conductor facing side.

In an advantageous embodiment, the housing further comprises locating ribs upstanding from the base wall within the internal cavity, upper edges of the locating ribs positioned against the magnetic core part.

In an advantageous embodiment, the circuit board comprises slots receiving the locating ribs therethrough.

In an advantageous embodiment, the magnetic core part comprises a substantially linear beam portion and at each core end a transverse projecting stub portion.

In an advantageous embodiment, the housing comprises one or more locating elements protruding outwardly from one or more lateral sides of the housing.

In an advantageous embodiment, the locating ribs comprise at least one locating rib on each of at least three side walls of the housing.

In an advantageous embodiment, the housing comprises a base portion including the base wall and the side walls, and a cover portion separately formed from the base portion and configured to be assembled to the base portion to close the internal cavity.

In an advantageous embodiment, the current transducer module further comprises electrical contacts connected to the circuit board and extending from the circuit board through the top wall for connection to external contacts.

Also disclosed herein is a system comprising the current transducer module according to any preceding embodiment and a primary conductor module, wherein the current transducer module is configured to be mounted on the primary conductor module; and the primary conductor module comprises a housing, a primary conductor bar lodged partially within the housing, and a magnetic core part mounted in the housing adjacent a first side of the primary conductor bar such that the magnetic core part of the primary conductor module and the magnetic core part of the current transducer module surround the primary conductor bar and define airgaps in which the magnetic field detectors are positioned.

Further advantageous features of the invention will be apparent from the following detailed description of embodiments of the invention and the accompanying illustrations.

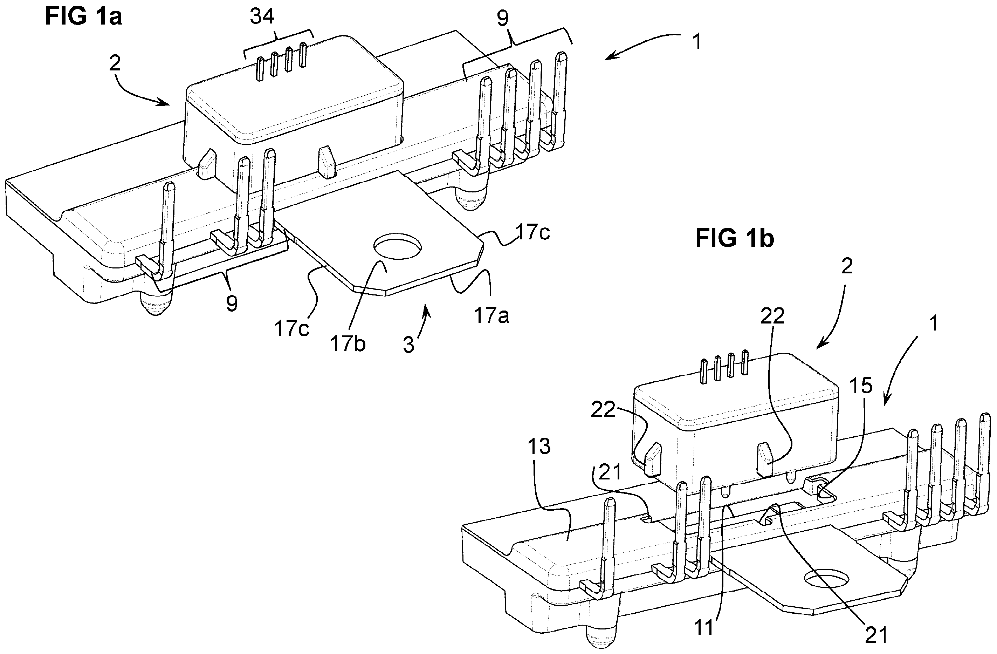

Figure 1a is a perspective view of a current transducer module according to an embodiment of this invention mounted on a primary conductor module;
Figure 1b is a view of the system of figure 1a with the current transducer module uncoupled and about to be connected to the primary conductor module;

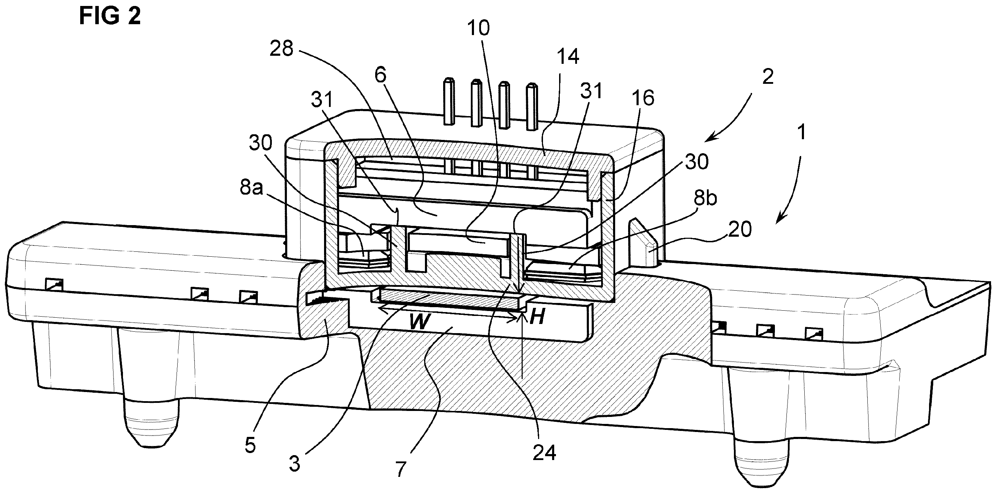

Figure 2 is a perspective partial cross-sectional view of the system of figure 1a;

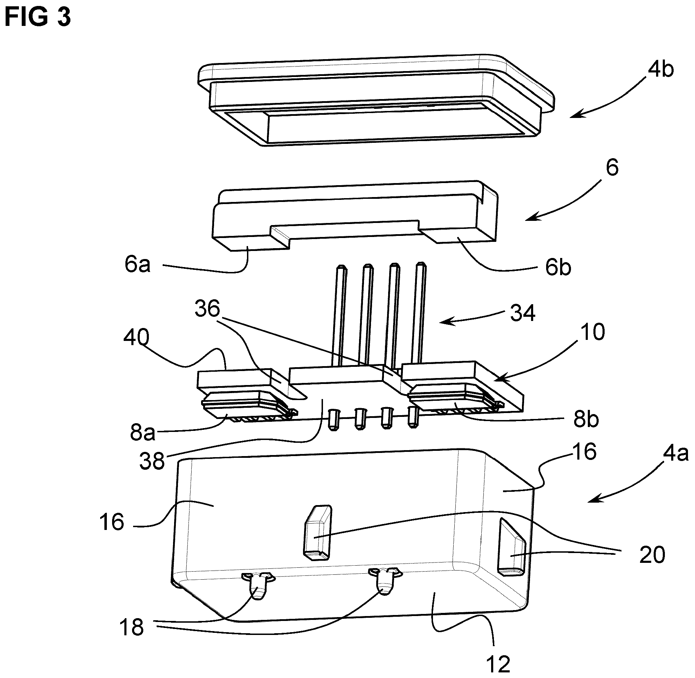

Figure 3 is an exploded view of the current transducer module according to an embodiment of the invention;
Figure 4a is a schematic perspective partial cut-away view of a current transducer module according to another embodiment of the invention;
Figure 4b is a schematic perspective view of the current transducer module of figure 4a with the housing removed.

Referring to the figures a current transducer module 2 configured to be assembled to a primary conductor module 1 of an external system, such as a power inverter for an electrical drive, is illustrated.

The primary conductor module 1 comprises a housing 5, a primary conductor bar 3 carrying a primary current for instance powered by a power inverter for supplying a phase current to an electrical motor. The primary conductor module may comprise a circuit board (not shown) and contacts 9 for power and signal communication with electronic components on the circuit board of the primary conductor module 1. The primary conductor module 1 further comprises a magnetic core part 7 positioned adjacent a first side 17a of the primary conductor bar 3, opposite a second side 17b of the primary conductor bar 3 facing an interface surface configured for receiving the current transducer module 2. The primary conductor bar 3 may have a substantially rectangular cross-section with a width ***W*** and a height ***H*,** with first and second opposed major surfaces defining above mentioned first and second sides 17a, 17b, and third and fourth opposed minor surfaces 17c.

The current transducer module 2 comprises a housing defining an internal cavity 28, and a magnetic core part 6, magnetic field detectors 8a, 8b, and a circuit board 10 mounted in the internal cavity 28. The housing 4 has an outer primary conductor mounting side 12, a top wall side 14, and lateral sides 16 joining the top wall side to the primary conductor mounting side 12. The primary conductor mounting side 12 is configured to be mounted against a transducer receiving side 11 of the primary conductor module 1.

The transducer receiving side 11 may advantageously be recessed relative to an outer surface 13 of the primary conductor module 1 such that the current transducer module 2 is partially inserted into the recess when assembled to the primary conductor module 1. The recess is surrounded by a recess side wall 15 having a perimeter with the shape of the perimeter of the primary conductor mounting side 12 of the current transducer module 2.

The primary conductor mounting side 12 of the current transducer module has a flat portion in a mounting plane ***M*** parallel or substantially parallel to the plane of the second side of the primary conductor bar 3 when the current transducer module 2 is assembled to the primary conductor module 1.

The magnetic field detectors 8a, 8b comprise first and second magnetic field detectors mounted on the circuit board 10 in a spaced apart relationship with the spacing corresponding substantially to the width ***W*** of the primary conductor bar 3. Each magnetic field detector 8a, 8b is thus configured to be positioned approximately adjacent a corresponding minor side 17c of primary conductor bar 3.

The magnetic core part 6 comprises a substantially linear beam shape extending between first and second ends, each end overlying a corresponding one of the magnetic field detectors 8a, 8b. The magnetic core may comprise short stubs 6a, 6b extending from each end towards the corresponding magnetic field detector such that the magnetic core part forms a flat "U" shaped part. The magnetic field detectors are mounted on a first side, forming a primary conductor facing side 38 of the circuit board 10, and the magnetic core part is mounted on the opposite second side 40 of the circuit board 10. The circuit may be provided with further electrical or electronic components (not shown) and comprise contacts 34 for signal and power interconnection to the circuit board including the magnetic field detectors 8a, 8b. The magnetic field detectors 8a, 8b may be in the form of ASICs (Application Specific Integrated Circuits) comprising for instance Hall effect magnetic field detector as *per se* well known in the art of current transducers.

The housing 4 may comprise locating ribs 30 formed in the internal cavity 28 upstanding from a base wall 24 of the housing, the locating ribs 30 having an upper edge 31 adjacent the magnetic core part 6 and against which the magnetic core part 6 may rest and be positioned. The locating ribs 30 may thus serve as positioning elements that accurately position the core ends 6a, 6b of the magnetic core part 6 relative to the base wall 24 and thus to the primary conductor mounting side surface 12 of the housing 4. This ensures a calibrated accurate airgap distance formed between the magnetic core part core ends 6a, 6b and the core ends 7a, 7b of the magnetic core part 7 in the primary conductor module 1 when the current transducer module is placed against the transducer receiving side 11 of the primary conductor module 1.

The circuit board 10 is provided with corresponding slots 36 for receiving the locating elements 20 therethrough.

The position of the circuit board 10 relative to the base wall 24 of the housing may be provided by one or more protuberances upstanding from the base wall configured to provide a gap between the first side 38 of the circuit board and the base wall 24 to fit the thickness of the magnetic field detectors 8a, 8b. The magnetic field detectors in the form of ASICs, are thus sandwiched between the circuit board 10 and the housing base wall 24.

When the base wall 24 of the current transducer module is mounted against the transducer module receiving side the surface 11 of the primary conductor module 1, the core ends 6a, 6b of the magnetic core part 6 and the magnetic field detectors 8a, 8b are positioned substantially opposite and facing the magnetic core part ends 7a, 7b of the magnetic core part 7 mounted in the primary conductor module 1. The magnetic field detectors 8a, 8b are thus positioned in airgaps formed by the two magnetic core parts 6, 7 when the current transducer module 2 is assembled to the primary conductor module 1, the magnetic core parts 7, 6 surrounding the primary conductor bar 3.

The housing 4 of the current transducer module advantageously comprises locating elements 20 formed on one or more lateral sides 16 cooperating with complementary locating elements 21 formed on a corresponding one or more lateral sides of the recess side wall 15 of the housing 5 of the primary conductor module 1. The locating elements 20 may for instance be in the form of protuberances (flanges, ribs) extending outwardly from the lateral sides 16, engaging in complementary cavities or slots formed in the recess side wall 15 of the primary conductor module housing 5. The locating elements 20 serve to ensure correct assembly and accurate registration of the current transducer module 2 to the primary conductor module 1 when the two parts are assembled together.

The current transducer module may further be provided with mounting posts 18 extending from the primary conductor mounting side 12 of the base wall 24 for insertion in corresponding mounting holes in the receiving side 11 of the primary conductor module housing 5. The current transducer module 2 may be welded, adhesively bonded, or fixed by screws or other mechanical fixing means to the primary conductor module 1 once assembled thereto.

The housing 4 of the current transducer module may advantageously be provided in two parts comprising a base portion 4a including the base wall 24 and side walls 26 upstanding therefrom defining the internal cavity 28, and a cover portion 4b that mounts to the base portion to close the internal cavity 28, the cover portion 4b forming a top wall 14.

In a variant, the housing 4 may be provided without a cover part, and the internal cavity 28 filled with an insulating potting material, or even without a potting material, simply covered by an external unit that mounts over the top of the transducer module and connects to the contacts 34.

The cover portion 4b may be provided with orifices to receive the contacts 34 therethrough for plugging connection or for solder or weld connection to contacts of an external circuit, for instance an external circuit board that may be mounted against the top wall 14 of the housing. The contacts 9 of the primary conductor module 1 may be connected to the same external circuit board as the contacts 34 of the current transducer module 2.

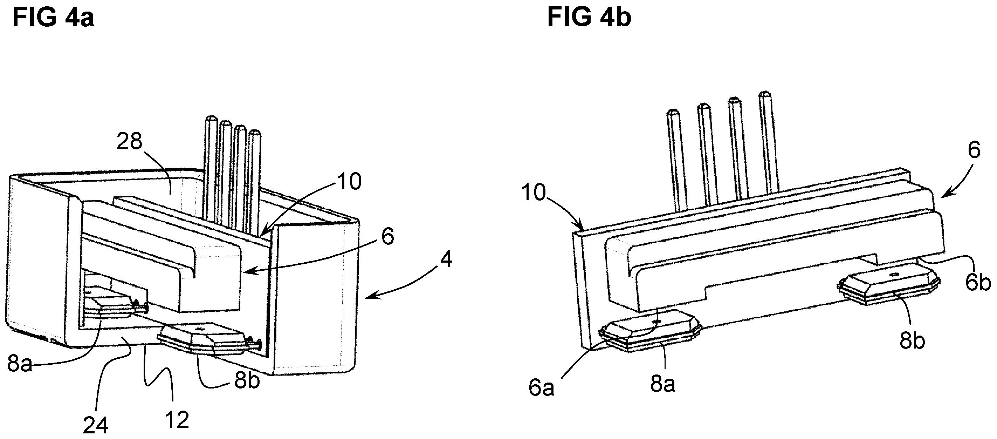

Referring to figures 4a, 4b, in a variant, the circuit board may be arranged upstanding with respect to the base wall 42 and the core ends 6a, 6b facing directly adjacent the magnetic field detectors 8a, 8b such that the magnetic field detectors are positioned in a gap between the housing base wall and the magnetic core part without the circuit board therebetween. The housing 4 of the current transducer module of figure 4a also comprises locating elements (not visible in the cut-away perspective view) formed on one or more lateral sides similar to the first described embodiment.

### List of references

Primary conductor module 1
   Primary conductor bar 3
      First and second major sides 17a, 17b
      Minor sides 17c
   Housing 5
      transducer receiving side 11
      outer surface 13
      recess side wall 15
      locating elements 21
   Magnetic core part 7
   Contacts 9
   Circuit board
Current transducer module 2
   housing 4
      primary conductor mounting side 12
         mounting posts 18
      top wall 14
      lateral sides 16
         locating elements 20
         protuberance
   base portion 4a
      base wall 24
      side walls 26
      internal cavity 28
         locating ribs 30
         upper edge 31
   cover portion 4b
      top wall 14
   **magnetic core part 6**
      core ends 6a, 6b
   **magnetic field detectors 8a, 8b**
      ASICs
   contacts 34
   **circuit board 10**
      housing slots 36
      first (primary conductor facing) side 38
      second side 40
*primary conductor bar cross-section width **W** and height **H***

## Claims

1. A current transducer module (2) comprising
- a housing having a base wall (24) and side walls (26) forming an internal cavity (28),
- a magnetic core part (6),
- magnetic field detectors (8a, 8b), and
- a circuit board (10),
the magnetic core part, magnetic field detectors, and the circuit board mounted within the internal cavity (28) of the housing (4),
the magnetic core part (6) extending from a first core end (6a) to a second core end (6b), the magnetic field detectors comprising a first magnetic field detector (8a) positioned opposite the first core end (6a) and a second magnetic detector (8b) positioned opposite the second core end (6b), the magnetic field detectors (8a, 8b) connected to the circuit board and arranged substantially co-planar with respect to each other, **characterized in that** the magnetic field detectors (8a, 8b) are mounted against the base wall (24) of the housing (4) and the magnetic core part is mounted above the magnetic field detectors such that the magnetic field detectors are positioned in a gap between the housing base wall and the magnetic core part.

2. The current transducer module according to the preceding claim wherein the magnetic field detectors are mounted on a first primary conductor facing side (38) of the circuit board (10) and the magnetic core part is mounted on a second side (40) of the circuit board (10), opposite the first primary conductor facing side (38).

3. The current transducer module according to any preceding claim wherein the housing (4) further comprises locating ribs (30) upstanding from the base wall (24) within the internal cavity (28), upper edges (31) of the locating ribs (30) positioned against the magnetic core part (6).

4. The current transducer module according to the preceding claim when dependent on claim 2, wherein the circuit board (10) comprises slots (36) receiving the locating ribs (30) therethrough.

5. The current transducer module according to any preceding claim wherein the magnetic core part (6) comprises a substantially linear beam portion and at each core end (6a, 6b) a transverse projecting stub portion.

6. The current transducer module according to any preceding claim wherein the housing (4) comprises one or more locating elements (20) protruding outwardly from one or more lateral sides (16) of the housing.

7. The current transducer module according to the preceding claim wherein the locating ribs (30) comprise at least one locating rib on each of at least three side walls of the housing.

8. The current transducer module according to any preceding claim wherein the housing comprises a base portion (4a) including the base wall (24) and the side walls (26), and a cover portion (4b) separately formed from the base portion (4a) and configured to be assembled to the base portion to close the internal cavity (28).

9. The current transducer module according to any preceding claim further comprising electrical contacts (34) connected to the circuit board (10) and extending from the circuit board (10) through the top wall (14) for connection to external contacts.

10. A system comprising the current transducer module according to any preceding claim and a primary conductor module (1), wherein: the current transducer module is configured to be mounted on the primary conductor module (1); and the primary conductor module comprises a housing (5), a primary conductor bar (3) lodged partially within the housing, and a magnetic core part (7) mounted in the housing (5) adjacent a first side of the primary conductor bar (3) such that the magnetic core part of the primary conductor module and the magnetic core part of the current transducer module surround the primary conductor bar and define airgaps in which the magnetic field detectors (8a, 8b) are positioned.

## Patentansprüche

1. Stromwandlermodul (2), umfassend:
- ein Gehäuse, das eine Basiswand (24) und Seitenwände (26) aufweist, die einen inneren Hohlraum (28) bilden,
- einen Magnetkernteil (6),
- Magnetfelddetektoren (8a, 8b), und
- eine Leiterplatte (10),
wobei der Magnetkernteil, die Magnetfelddetektoren und die Leiterplatte innerhalb des internen Hohlraums (28) des Gehäuses (4) montiert sind,
wobei der Magnetkernteil (6) sich von einem ersten Kernende (6a) zu einem zweiten Kernende (6b) erstreckt, die Magnetfelddetektoren einen ersten Magnetfelddetektor (8a), der entgegengesetzt zum ersten Kernende (6a) positioniert ist, und einen zweiten Magnetdetektor (8b) umfassen, der entgegengesetzt zum zweiten Kernende (6b) positioniert ist, wobei die Magnetfelddetektoren (8a, 8b) mit der Leiterplatte verbunden sind und im Wesentlichen koplanar in Bezug aufeinander eingerichtet sind, **dadurch gekennzeichnet, dass** die Magnetfelddetektoren (8a, 8b) gegen die Basiswand (24) des Gehäuses (4) montiert sind und der Magnetkernteil derart über den Magnetfelddetektoren montiert ist, dass die Magnetfelddetektoren in einem Spalt zwischen der Gehäusebasiswand und dem Magnetkernteil positioniert sind.

2. Stromwandlermodul nach dem vorhergehenden Anspruch, wobei die Magnetfelddetektoren auf einer ersten, dem Primärleiter zugewandten Seite (38) der Leiterplatte (10) montiert sind und der Magnetkernteil auf einer zweiten Seite (40) der Leiterplatte (10) montiert ist, die der ersten, dem Primärleiter zugewandten Seite (38) entgegengesetzt ist.

3. Stromwandlermodul nach einem der vorhergehenden Ansprüche, wobei das Gehäuse (4) ferner Fixierungsrippen (30) umfasst, die von der Basiswand (24) innerhalb des inneren Hohlraums (28) nach oben stehen, wobei obere Kanten (31) der Fixierungsrippen (30) gegen den Magnetkernteil (6) positioniert sind.

4. Stromwandlermodul nach dem vorhergehenden Anspruch, wenn abhängig von Anspruch 2, wobei die Leiterplatte (10) Schlitze (36) umfasst, welche die Fixierungsrippen (30) dort hindurch aufnehmen.

5. Stromwandlermodul nach einem der vorhergehenden Ansprüche, wobei der Magnetkernteil (6) einen im Wesentlichen linearen Trägerabschnitt und an jedem Kernende (6a, 6b) einen quer hervorstehenden Ansatzabschnitt umfasst.

6. Stromwandlermodul nach einem der vorhergehenden Ansprüche, wobei das Gehäuse (4) ein oder mehrere Fixierungselemente (20) umfasst, die von einer oder mehreren seitlichen Seiten (16) des Gehäuses nach außen hervorstehen.

7. Stromwandlermodul nach dem vorhergehenden Anspruch, wobei die Fixierungsrippen (30) mindestens eine Fixierungsrippe auf jeder der mindestens drei Seitenwände des Gehäuses umfassen.

8. Stromwandlermodul nach einem der vorhergehenden Ansprüche, wobei das Gehäuse einen Basisabschnitt (4a), der die Basiswand (24) und die Seitenwände (26) umfasst, und einen Abdeckungsabschnitt (4b) umfasst, der getrennt von dem Basisabschnitt (4a) gebildet ist und dazu ausgestaltet ist, mit dem Basisabschnitt zusammengebaut zu sein, um den inneren Hohlraum (28) zu schließen.

9. Stromwandlermodul nach einem der vorhergehenden Ansprüche, der ferner elektrische Kontakte (34), die mit der Leiterplatte (10) verbunden sind und sich von der Leiterplatte (10) durch die obere Wand (14) erstrecken, zur Verbindung mit externen Kontakten umfasst.

10. System, welches das Stromwandlermodul nach einem der vorhergehenden Ansprüche und ein Primärleitermodul (1) umfasst, wobei: das Stromwandlermodul dazu ausgestaltet ist, an dem Primärleitermodul (1) montiert zu sein; und das Primärleitermodul ein Gehäuse (5), eine Primärleiterschiene (3), die teilweise innerhalb des Gehäuses untergebracht ist, und einen Magnetkernteil (7) umfasst, der derart in dem Gehäuse (5) benachbart zu einer ersten Seite der Primärleiterschiene (3) montiert ist, dass der Magnetkernteil des Primärleitermoduls und der Magnetkernteil des Stromwandlermoduls die Primärleiterschiene umgeben und Luftspalten definieren, in denen die Magnetfelddetektoren (8a, 8b) positioniert sind.

## Revendications

1. Module de transducteur de courant (2) comprenant :
un boîtier ayant une paroi de base (24) et des parois latérales (26) formant une cavité interne (28),
une partie de noyau magnétique (6),
des détecteurs de champ magnétique (8a, 8b), et
une carte de circuit imprimé (10),
la partie de noyau magnétique, les détecteurs de champ magnétique et la carte de circuit imprimé montés dans la cavité interne (28) du boîtier (4),
la partie de noyau magnétique (6) s'étendant à partir d'une première extrémité de noyau (6a) jusqu'à une seconde extrémité de noyau (6b), les détecteurs de champ magnétique comprenant un premier détecteur de champ magnétique (8a) positionné à l'opposé de la première extrémité de noyau (6a) et un second détecteur de champ magnétique (8b) positionné à l'opposé de la seconde extrémité de noyau (6b), les détecteurs de champ magnétique (8a, 8b) étant raccordés à la carte de circuit imprimé et agencés de manière sensiblement coplanaire l'un par rapport à l'autre, **caractérisé en ce que** les détecteurs de champ magnétique (8a, 8b) sont montés contre la paroi de base (24) du boîtier (4) et la partie de noyau magnétique est montée au-dessus des détecteurs de champ magnétique de sorte que les détecteurs de champ magnétique sont positionnés dans un entrefer entre la paroi de base du boîtier et la partie de noyau magnétique.

2. Module de transducteur de courant selon la revendication précédente, dans lequel les détecteurs de champ magnétique sont montés sur un premier côté faisant face au conducteur primaire (38) de la carte de circuit imprimé (10) et la partie de noyau magnétique est montée sur un second côté (40) de la carte de circuit imprimé (10), opposé au premier côté faisant face au conducteur primaire (38).

3. Module de transducteur de courant selon l'une quelconque des revendications précédentes, dans lequel le boîtier (4) comprend en outre des nervures de positionnement (30) se dressant à partir de la paroi de base (24) dans la cavité interne (28), les bords supérieurs (31) des nervures de positionnement (30) étant positionnés contre la partie de noyau magnétique (6).

4. Module de transducteur de courant selon la revendication précédente, lorsqu'elle dépend de la revendication 2, dans lequel la carte de circuit imprimé (10) comprend des fentes (36) recevant les nervures de positionnement (30) à travers ces dernières.

5. Module de transducteur de courant selon l'une quelconque des revendications précédentes, dans lequel la partie de noyau magnétique (6) comprend une partie de poutre sensiblement linéaire et au niveau de chaque d'extrémité de noyau (6a, 6b), une partie de tronçon transversale en saillie.

6. Module de transducteur de courant selon l'une quelconque des revendications précédentes, dans lequel le boîtier (4) comprend un ou plusieurs éléments de positionnement (20) faisant saillie vers l'extérieur à partir d'un ou de plusieurs côtés latéraux (16) du boîtier.

7. Module de transducteur de courant selon la revendication précédentes, dans lequel les nervures de positionnement (30) comprennent au moins une nervure de positionnement sur chacune d'au moins trois parois latérales du boîtier.

8. Module de transducteur de courant selon l'une quelconque des revendications précédentes, dans lequel le boîtier comprend une partie de base (4a) comprenant la paroi de base (24) et les parois latérales (26), et une partie de couvercle (4b) formée séparément de la partie de base (4a) et configurée pour être assemblée à la partie de base pour fermer la cavité interne (28).

9. Module de transducteur de courant selon l'une quelconque des revendications précédentes, comprenant en outre des contacts électriques (34) raccordés à la carte de circuit imprimé (10) et s'étendant à partir de la carte de circuit imprimé (10) à travers la paroi supérieure (14) pour le raccordement aux contacts externes.

10. Système comprenant le module de transducteur de courant selon l'une quelconque des revendications précédentes et un module de conducteur primaire (1), dans lequel : le module de transducteur de courant est configuré pour être monté sur le module de conducteur primaire (1) ; et le module de conducteur primaire comprend un boîtier (5), une barre de conducteur primaire (3) logée partiellement à l'intérieur du boîtier et une partie de noyau magnétique (7) montée dans le boîtier (5) adjacent à un premier côté de la barre de conducteur primaire (3), de sorte que la partie de noyau magnétique du module de conducteur primaire et la partie de noyau magnétique du module de transducteur de courant entourent la barre de conducteur primaire et définit des entrefers dans lesquels sont positionnés les détecteurs de champ magnétique (8a, 8b).
